# EUROPÄISCHE PATENTSCHRIFT

(11) **EP 2 958 734 B1**
(45) Veröffentlichungstag und Bekanntmachung des Hinweises auf die Patenterteilung: **26.09.2018**
(21) Anmeldenummer: 14702858.3
(22) Anmeldetag: 05.02.2014
(51) Int. Cl.: B29C 65/00

(54) **GEHÄUSE MIT EINER ROTATIONSREIBSCHWEISSNAHT**
HOUSING WITH A ROTATIONAL FRICTION WELDING SEAM
BOÎTIER COMPORTANT UN JOINT DE SOUDAGE PAR ROTATION

(30) Priorität: 21.02.2013 DE 102013101727
(43) Veröffentlichungstag der Anmeldung: 30.12.2015
(73) Patentinhaber: R. Stahl Schaltgeräte GmbH, 74638 Waldenburg (DE)
(72) Erfinder: HERMANN, Wolf, 74613 Öhringen (DE); SCHWARZ, Normen, 99423 Weimar (DE)
(74) Vertreter: Rüger Abel
(86) Internationale Anmeldenummer: PCT/EP2014/052262
(87) Internationale Veröffentlichungsnummer: WO 2014/127996

(56) Entgegenhaltungen:
- EP-A2- 1 255 072
- WO-A2-2010/026533
- DE-A1-102006 017 170
- KR-A- 20110 128 765
- THEWS H: "REIBSCHWEISSEN. ROTATIONSREIB- UND VIBRATIONSSCHWEISSEN", KUNSTOFFE, CARL HANSER VERLAG, MUNCHEN, DE, Bd. 71, Nr. 10, 1. Oktober 1981 (1981-10-01), Seiten 764-768, XP000677087, ISSN: 0023-5563
- "Orbi-Tech - Kunststoff-Schweißdraht, Schweißmaschinen und Zubehör", , 1. Januar 2005 (2005-01-01), XP055135842, Gefunden im Internet: URL:http://www.orbi-tech.de/seiten_deutsch /rotationsreibschweissen.htm [gefunden am 2014-08-21]

## Beschreibung

Gegenstand der Erfindung ist ein Gehäuse insbesondere für elektrische Betriebsmittel, wobei das Gehäuse eine Rotationsreibschweißnaht aufweist, und ein Verfahren zur Herstellung eines solchen.

Zur Herstellung von rohrförmigen Gehäusen, insbesondere druckfesten Gehäuse, werden zum endseitigen Abschluss häufig Zugstangenkonstruktionen oder Verschlüsse mit Vergussmassen eingesetzt, zu deren Montage eine spezielle mechanische Vorbereitung erforderlich ist. Die EP 1 255 072 A2 zeigt beispielsweise eine explosionsgeschützte Leuchte mit einem lichtdurchlässigen Gehäuserohr, deren Gehäuseteile mit Hilfe zweier Zuganker verbunden sind. Die Fertigung und Montage solcher Konstruktionen ist jedoch aufwendig.

Zur Verbindung von thermoplastischen Kunststoffen ist außerdem das Verfahren des Rotationsreibschweißens bekannt. Hierbei wird die erforderliche Wärme zur Aufschmelzung der Materialien durch die relative Rotation der zu verbindenden Teile aufgebracht. Da ein Reibschweißvorgang maximal einige Sekunden dauert, können auf diese Weise Gegenstände mit einer hohen Taktzahl hergestellt werden.

KR 10 2011 0 128 765 A zeigt eine Filterbaugruppe mit einem Gehäuse und einem Deckel. Die Filtereinheit soll Wasser filtern, das in das Filtergehäuse eingebracht wird. An einer Kante des Filtergehäuses ist eine Schweißrippe angeordnet, die in eine Schweißnut, gebildet an dem Gehäusedeckel, eingeführt wird. Das Gehäuse und der Deckel werden anschließend durch Reibschweißen miteinander verbunden.

Die DE 38 53 951 T2 beschreibt einen Kunststoffbehälter, der druckbeständig ist und der ein rohrförmiges Körperteil und Endverschlussteile aufweist, wobei an dem Rand eines Endverschlussteils eine ringförmige Vertiefung angeordnet ist. Das Ende des rohrförmigen Körperteils wird in der Vertiefung platziert. Danach werden das Endverschlussteil sowie das rohrförmige Körperteil unter Aufschmelzung des Endes des rohrförmigen Körperteils durch Rotationsreibschweißen verbunden. Dies wird durch eine Hinterschneidung unterstützt, die an der Vertiefung angeordnet ist, und in die das aufgeschmolzene Material des Endes einfließt. Das Gehäuse wird dadurch fluiddicht geschlossen und ist zur Aufnahme von unter statischem Druck stehenden Fluiden eingerichtet, wobei beispielsweise Drücke von etwa 10 bar auf den Behälterkörper wirken können.

Die DE 199 11 284 A1 beschreibt ein Verfahren zur Ausbildung einer Muffenverbindung zweier Rohre. Die sich leicht zur Mitte konisch verjüngende Muffe wird in Rotationsbewegung gebracht. Die drehfest gelagerten Rohre werden entlang der Rotationsachse der Muffe in diese eingefahren, so dass es zu einem Aufschmelzen des Muffen- und Rohrmaterials und zur Ausbildung einer Rotationsreibschweißnaht kommt. Die Muffe und die Rohre weisen eine vergleichbare Radialelastizität auf. Anders ist dies bei der Verbindung einer relativ starren Kappe oder eines Deckels für ein Gehäuse mit einem relativ dazu elastischen zylinderförmigen Grundkörper. Bei Wechselwärmebeanspruchung besteht die Gefahr einer Rissbildung, insbesondere am axialen Übergang der Kappe auf das Rohr. Zudem kann es bei einer Explosion inner- oder außerhalb des Gehäuses, d.h. bei einer stoßartigen Druckbelastung, insbesondere an einem solchen Übergang von einer Kappe oder auch einer Muffe auf das Rohr zu einem Abscheren des Grundkörpers kommen.

Aufgabe der Erfindung ist es, ein verbessertes Gehäuse insbesondere für elektrische Betriebsmittel und ein Verfahren zur Herstellung eines solchen zu schaffen.

Diese Aufgabe wird erfindungsgemäß mit einem Gehäuse mit den Merkmalen nach Anspruch 1 sowie einem Verfahren nach Anspruch 13 gelöst.

Das Gehäuse ist insbesondere zur Aufnahme elektrischer Betriebsmittel eingerichtet, kann jedoch auch als Gehäuse für andere Vorrichtungen dienen. Das Gehäuse weist ein erstes Teil mit einer ersten Wand auf, die eine z.B. zylindrische Außenwandfläche aufweist. Ein zweites Teil des Gehäuses mit einer zweiten Wand weist eine Innenwandfläche auf, die z.B. zylindrisch ausgebildet sein kann. Die erste Wand und die zweite Wand überlappen in einen Überlappungsbereich und sind innerhalb des Überlappungsbereiches mit einer Rotationsreibschweißnaht auf den Wandflächen entlang ihres Umfangs verbunden. Die Rotationsreibschweißnaht bildet einen kreisförmigen, in sich geschlossenen Ring. Die Rotationsreibschweißnaht wird konzentrisch zur Mittelachse des Gehäuses festgelegt, die gleichzeitig die Rotationsachse des Gehäuses bildet.

Das Gehäuse ist explosionsgeschützt nach der Schutzart druckfeste Kapselung (Ex-d) und/oder nach der Schutzart erhöhte Sicherheit (Ex-e) ausgebildet.

Die Rotationsreibschweißnaht weist wenigstens eine Kompaktzone und eine Mischzone auf. Die Kompaktzone weist vorzugsweise eine homogene Materialverteilung auf. Die Mischzone weist vorzugsweise eine inhomogene Materialverteilung auf. Die Kompaktzone ist durch vollständig aufgeschmolzenes Material hergestellt. Die Mischzone enthält teilweise aufgeschmolzenes Material. Die Rotationsreibschweißnaht kann eine einzige oder mehrere Mischzonen und eine einzige oder mehrere Kompaktzonen aufweisen. Durch die Kompaktzone und die Mischzone können Zonen unterschiedlicher Elastizität geschaffen sein. Insbesondere die Mischzone kann dabei als radiale Übergangszone zwischen einem ersten Teil und einem zweiten Teil mit unterschiedlicher, insbesondere quer zur Rotationsachse unterschiedlicher, Elastizität wirken. Eine Mischzone kann beispielsweise Poren, sonstige Hohlräume, Festkörperabrieb und/oder Festkörperbruchstücke und/oder Schlieren und/oder Lamellen erstarrter Schmelze enthalten. Die Mischzone weist mechanische Eigenschaften auf, die sich von den mechanischen Eigenschaften der Kompaktzone unterscheiden. Insbesondere weist die Mischzone eine höhere Nachgiebigkeit auf als die Kompaktzone, d.h. die Mischzone bringt bei Verformung einen geringeren Widerstand auf.

Die Mischzone ist vorzugsweise an einem axialen Ende der Rotationsreibschweißnaht angeordnet. In der Rotationsreibschweißnaht kann an beiden axialen Enden jeweils eine Mischzone ausgebildet sein, die durch eine Kompaktzone axial getrennt sind. Vorzugsweise ist eine Mischzone an einem axialen Randbereich des Überlappungsbereichs angeordnet, d.h. entlang der Rotationsachse dort, wo sich der Übergang von dem Überlappungsbereich auf das erste Teil oder das zweite Teil befindet. Die Kompaktzone kann beispielsweise axial in der Mitte der Rotationsreibschweißnaht angeordnet sein. Die Kompaktzone kann sich auch von einem Bereich in der axialen Mitte der Rotationsreibschweißnaht bis zu einem axialen Ende der Rotationsreibschweißnaht erstrecken.

Zwischen der Kompaktzone und der Mischzone kann parallel zu der Rotationsachse ein gleichmäßiger oder abrupter Übergang geschaffen sein. Der Übergang zwischen der Kompaktzone und der Mischzone kann entlang des Umfangs einer geraden Linie folgen oder kurven- bzw. wellenförmig sein, das heißt die Kompaktzone kann entlang parallel zur Rotationsachse beispielsweise in die Mischzone eingreifen. Die Kompaktzone kann parallel zu der Rotationsachse eine größere Erstreckung (Länge) aufweisen als die Mischzone.

Kompaktzonen und Mischzonen können einander abwechselnd entlang des Umfangs der Rotationsreibschweißnaht angeordnet sein und sich beispielsweise jeweils parallel zu der Rotationsachse erstrecken. Eine oder mehrere Mischzonen können als Flecken oder Inseln in einer Kompaktzone ausgebildet sein, wobei die Kompaktzone beispielsweise zusammenhängend sein kann. Auch können eine oder mehrere Kompaktzonen als Flecken oder Inseln in einer Mischzone ausgebildet sein, wobei die Mischzone beispielsweise zusammenhängend sein kann. Flecken von Kompaktzonen bzw. Mischzonen können regelmäßig angeordnet sein oder ein unregelmäßiges Muster bilden. Entsprechend können Kompaktzonen- und Mischzonenflecken in Umfangsrichtung und/oder in Richtung der Rotationsachse einander abwechselnd angeordnet sein.

Das aufgeschmolzene und wieder erstarrte Material in der Kompaktzone ist vorzugsweise dichter als das Material der Mischzone. Es kann z.B. weniger Poren, Festkörperabrieb oder dergleichen aufweisen. Die Kompaktzone ist dazu eingerichtet, den Zusammenhalt des Gehäuses insbesondere bei Kräften parallel zu der Rotationsachse zu bewirken. Durch die Kompaktzone kann insbesondere Dichtigkeit des Gehäuses erreicht werden. Die Mischzone ist insbesondere zur mechanischen Sicherung des Übergangs von dem ersten auf das zweite Teil eingerichtet und kann als Pufferzone wirken. Durch die Inhomogenität der Mischzone kann diese selbst bei Verwendung von glasklarem Kunststoff trüb oder sogar undurchsichtig sein.

Vorzugsweise erstreckt sich die Rotationsreibschweißnaht axial über den gesamten Überlappungsbereich. Die Erstreckung der Rotationsreibschweißnaht parallel zu der Rotationsachse ist vorzugsweise auf den Überlappungsbereich beschränkt. Die Rotationsreibschweißnaht kann sich jedoch auch wenigstens einseitig über den Überlappungsbereich hinaus erstrecken. Beispielsweise kann erstarrte Schmelze auch außerhalb des Überlappungsbereichs angeordnet sein und dort beispielsweise zur mechanischen Stabilität und/oder Dichtigkeit der Reibschweißnaht beitragen. Vorzugsweise sind das erste Teil und das zweite Teil auf den Wandflächen entlang ihres gesamten Umfangs, das heißt entlang des Umfangs unterbrechungsfrei, verbunden.

Die (axialen) Längen der Kompakt und der Mischzone können sich unterscheiden und sind z.B. von Material- und Formparametern des ersten und zweiten Teils und zudem von Parametern des Herstellungsprozesses abhängig. Die Länge der Mischzone kann beispielsweise einige Millimeter betragen. Die Länge der Mischzone kann jedoch auch beispielsweise nur wenige hundertstel Millimeter betragen. Die Kompaktzone ist vorzugsweise länger als die Mischzone. Die Länge der Kompaktzone beträgt z.B. wenigstens 10 mm. Die Dicke der Kompaktzone und die Dicke der Mischzone einer Rotationsreibschweißnaht in radialer Richtung quer zu der Rotationsachse können sich unterscheiden. Die Mischzone kann radial dicker sein als die Kompaktzone. Dies fördert deren federnde und/oder plastische Verformbarkeit bzw. Nachgiebigkeit.

Das Gehäuse kann außer dem ersten und zweiten Teil weitere Teile aufweisen. Verbindungen zwischen Teilen des Gehäuses können als Rotationsreibschweißnähte ausgebildet oder auf andere Weise miteinander verbunden sein. Das Gehäuse oder ein Teil des Gehäuses kann durchsichtig oder lichtdurchlässig sein. Das Gehäuse ist vorzugsweise wasserdicht. Es ist vorteilhaft, wenn das Gehäuse nach der Schutzart druckfeste Kapselung Ex-d explosionsgeschützt ausgebildet ist. Besonders bevorzugt genügt das Gehäuse (insbesondere die Verbindungen von Gehäuseteilen) der DIN EN 60079-1. Das Gehäuse kann auch gemäß der Schutzart Ex-e ausgebildet sein. Es kann beispielsweise als Leuchtengehäuse oder als Gehäuse für Signalgeber oder dem geschützten Einbau von Kabeln, zum Beispiel als Kabelführung, dienen oder optische Sensoren beinhalten.

Das Gehäuse weist vorzugsweise einen zylindrischen oder rohrförmigen Körper auf. Das Gehäuse kann außerdem beispielsweise eine Kappe aufweisen, die dazu eingerichtet ist, den rohrförmigen Körper an einer Seite zu verschließen. Dazu wird die Kappe über den rohrförmigen Körper gestülpt und bildet mit diesem den Überlappungsbereich aus. Auf diese Weise wird der Überlappungsbereich zwischen dem ersten Teil (bspw. der rohrförmige Körper) und dem zweiten Teil (bspw. die Kappe) geschaffen. Der Überlappungsbereich des rohrförmigen Körpers mit der Kappe kann eine Rotationsreibschweißnaht mit einer Kompaktzone und einer Mischzone aufweisen. Ein Gehäuse kann auch einen rohrförmigen Körper aufweisen, indem zumindest an einer Seite des Körpers ein Stopfen angeordnet ist und diesen verschließt. Beispielsweise wird bei einem solchen Gehäuse das erste Teil durch den Stopfen und das zweite Teil durch den rohrförmigen Körper gebildet. Der Stopfen und der Körper können wiederum durch die vorbeschriebene Rotationsreibschweißnaht verbunden sein.

Das Gehäuse kann wenigstens ein rohrförmiges Teil aufweisen, das über eine erfindungsgemäße Rotationsreibschweißnaht mit einer Kompaktzone und einer Mischzone mit einer Muffe oder einem Nippel verbunden ist. Es können auch zwei rohrförmige Teile mit Rotationsreibschweißnähten mit Hilfe einer Muffe, eines Nippels oder untereinander direkt verbunden sein. Mit einer Muffe wird ein manschettenartiges Verbindungsstück bezeichnet, das um Endabschnitte beider rohrförmiger Teile zur Verbindung der Teile angeordnet ist. Ein Nippel ist ein innerhalb der rohrförmigen Teile in den Endabschnitten beider rohrförmiger Teile angeordnetes Verbindungsstück.

Das erste und das zweite Teil weisen jeweils eine Wand auf, die eine innen oder außen um die Wand herumführende Wandfläche aufweist. Eine solche Wandfläche kann glatt und rund oder eckig als Vielkantfläche ausgebildet sein oder Facetten aufweisen. Die Wandfläche kann im Querschnitt, das heißt quer zur Rotationsachse, kreisförmig oder elliptisch oder polygonal sein. Ein Teil mit der Wandfläche kann beispielsweise eine Rohrform aufweisen, wobei es sich dabei um eine zylindrisch runde oder eine Vielkantrohrform oder prismatische Rohrform handeln kann. Die Wandfläche kann parallel zu der Rotationsachse verlaufen und entlang der Rotationsachse einen konstanten Durchmesser bzw. Umfang aufweisen. Die Wandflächen haben eine "Mantelform". Dazu zählen Wandflächen mit einer geraden Zylindermantelform, beispielsweise auch konische Wandflächen oder gekrümmte Wandflächen, die einen Körper umfangen. Eine Wandfläche kann beispielsweise wenigstens teilweise von einer geraden Kegel- oder Zylinderwandform abweichend rund oder wellenförmig sein. Die mantelförmige Wandfläche kann sich beispielsweise auch wenigstens abschnittsweise in Richtung der Rotationsachse, beispielsweise konisch, erweitern oder verjüngen. Eine mantelförmige Wandfläche kann außerdem eine Stufe enthalten, d.h. einen sich abrupt ändernden Durchmesser. In einer mantelförmigen Wandfläche können ein oder mehrere Schlitze oder Spalte, beispielsweise in axialer Richtung, vorhanden sein. Auf diese Weise kann die Wandfläche entlang ihres Umfangs unterbrochen sein. Die Formen der Wandflächen der ersten und zweiten Wand können komplementär zueinander ausgebildet sein. Vorzugsweise ist eine konische bzw. eine von einer strengen Zylinderform abweichende Form wenigstens abschnittsweise durch einen Winkel charakterisiert, der die Schrägstellung einer Wandfläche in Bezug und Richtung zur Rotationsachse festlegt. Vorzugsweise beträgt der die Schrägstellung charakterisierende Winkel zwischen 1° bis 3°.

Wandflächen der ersten und/oder des zweiten Teils können Vertiefungen, wie beispielsweise Taschen, Riefen oder Nuten aufweisen. Solche Vertiefungen können beispielsweise der Aufnahme von Schmelze oder der Weiterleitung oder Lenkung des Schmelzeflusses oder der Kontrolle des Entstehens der Schmelze bei der Herstellung der Reibschweißnaht dienen. Vertiefungen sind vorzugsweise im Überlappungsbereich angeordnet und auf diesen beschränkt. Abschnitte einer Vertiefung können sich über den Überlappungsbereich erstrecken, bzw. über diesen wenigstens auf einer Seite des Überlappungsbereiches überstehen. Vertiefungen können längs und/oder quer zur Rotationsachse verlaufen. Vertiefungen, insbesondere Nuten oder Rillen, können entlang der Umfangsrichtung einer mantelförmigen Wandfläche verlaufen. Auf diese Weise kann eine Vertiefung einer Schraubenlinie auf der Wandfläche folgen. Eine Vertiefung kann entlang der Rotationsachse verlaufen. Vorzugsweise weist ein Teil mehrere in Umfangsrichtung laufende Nuten auf. Eine Wandfläche eines Teils, beispielsweise des ersten Teils, kann Vertiefungen aufweisen, während die Wandfläche des anderen Teils keine Vertiefungen aufweist. Das erste und zweite Teil können Kanäle, beispielsweise zur Kontrolle der Schmelzentstehung oder des Schmelzflusses aufweisen.

In einer Ausführungsform weist weder die erste noch die zweite Wandfläche Vertiefungen im Überlappungsbereich auf, wobei hier die Oberflächenrauheit ausgenommen ist. Auf diese Weise kann die Rotationsreibschweißnaht hinterschneidungsfrei ausgebildet sein.

Der Durchmesser eines ersten oder eines zweiten Teils kann bezogen auf die Wandfläche beispielsweise 10 mm bis 70 mm betragen. Die Dicke der Wand eines Teils richtet sich vorzugsweise nach dem Durchmesser des Teils und kann beispielsweise 1 mm bis 5 mm betragen.

Eine Wand und deren Wandfläche können aus demselben Material sein oder unterschiedlichen Materialien aufweisen. Die Wände des ersten und des zweiten Teils können aus demselben oder unterschiedlichen Materialien bestehen oder teilweise unterschiedliches Material aufweisen. Vorzugsweise bestehen die erste Wand und die zweite Wand aus Kunststoff oder weisen Kunststoff auf. Als Wandmaterial wird ein amorpher thermoplastischer Kunststoff bevorzugt. Eine Wand kann beispielsweise aus Polycarbonat bestehen. Möglich ist aber auch, dass von dem ersten und zweiten Teil beispielsweise nur die Wand eines Teils aus Kunststoff ist oder Kunststoff aufweist, während die andere Wand beispielsweise aus Glas, Metall oder Verbundmaterial besteht.

Die homogene Kompaktzone und/oder die inhomogene Mischzone der Reibschweißnaht können jeweils eine einzige Kunststoffsorte, wie beispielsweise Polycarbonat, oder mehrere Kunststoffsorten aufweisen bzw. beinhalten. Insbesondere können sowohl in der Kompaktzone als auch in der Mischzone Materialien von der ersten Wand und der zweiten Wand enthalten und vermischt sein.

Vorzugsweise weist das erste und das zweite Teil jeweils eine Stirnfläche auf. Eine Stirnfläche kann quer zu einer Wandfläche orientiert sein. Beispielsweise ist bei einer Ausführungsform mit einer Kappe und einem zylindrischen Rohr einerseits durch eine axiale Deckfläche an einem Ende des Rohrs eine Stirnfläche geschaffen, andererseits besitzt die Kappe eine Stirnfläche, die das Rohr axial verschließt. Zusätzlich zu der Verbindung durch die Rotationsreibschweißnaht können das erste und das zweite Teil durch eine axiale Rotationsreibschweißnaht auf Stirnflächen des ersten und des zweiten Teils verbunden sein. Beispielsweise kann in einer Muffe ein Ring angeordnet sein, der zwei Stirnflächen aufweist, wobei ein in der Muffe angeordnetes Rohr mit der Muffe mit einer Rotationsreibschweißnaht auf dem Umfang und einer axialen Rotationsreibschweißnaht auf einer Stirnfläche verbunden sein kann.

In einer Ausführungsform können das erste und das zweite Teil keine Reibschweißnaht an einer von einer Wandfläche gesonderten Stirnfläche aufweisen und somit durch eine Reibschweißnaht ausschließlich auf dem Umfang an den mantelförmigen Wandinnen- bzw. -außenflächen verbunden sein.

Das erfindungsgemäße Verfahren zur Herstellung eines explosionsgeschützt nach der Schutzart druckfeste Kapselung (Ex-d) und/oder nach der Schutzart erhöhte Sicherheit (Exe) ausgebildeten Gehäuses ist auf das Ausbilden einer Reibschweißnaht mit einer Kompaktzone und einer Mischzone ausgerichtet. Es dient der Herstellung eines Gehäuses, das für elektrische Betriebsmittel eingesetzt werden kann, und das eine Rotationsachse festlegt und ein erstes Teil mit einer ersten Wand und ein zweites Teil mit einer zweiten Wand aufweist. Die erste Wand weist eine mantelförmige Außenwandfläche und die zweite Wand eine mantelförmige Innenwandfläche auf. Zur Herstellung werden das erste Teil und das zweite Teil relativ zueinander um die Rotationsachse drehend angetrieben. Das erste Teil und das zweite Teil können in einer relativen Zustellbewegung aufeinander zubewegt werden. Bei einem Kontakt von Stirnflächen und/oder Umfangsflächen des ersten und des zweiten Teils kommt es zu einem Aufschmelzen des Materials wenigstens eines Teils einer Kontaktfläche. Durch die wiedererstarrte Schmelze wird schließlich eine Reibschweißnaht auf den Wandflächen ausgebildet, die eine Kompaktzone mit einer homogenen Materialverteilung und eine Mischzone mit einer inhomogenen Materialverteilung aufweist, wobei die Mischzone eine höhere Nachgiebigkeit als die Kompaktzone aufweist, wobei die Kompaktzone durch vollständig aufgeschmolzenes Material hergestellt ist, wobei die Mischzone in oder an einem axialen Randbereich des Überlappungsbereichs angeordnet ist, d.h. entlang der Rotationsachse dort, wo sich der Übergang von dem Überlappungsbereich auf das erste Teil oder das zweite Teil befindet, wobei die Mischzone teilweise aufgeschmolzenes Material enthält. Die Entstehung der Kompaktzone und der Mischzone und deren Eigenschaften, wie beispielsweise die Länge der Zonen in Richtung der Rotationsachse, kann durch Material-, Form- und Prozessparameter kontrolliert werden. Hierbei spielt beispielsweise der Durchmesser des ersten Teils und des zweiten Teils als Formparameter eine Rolle, wobei vorzugsweise eine Übermaßpassung zwischen dem ersten und dem zweiten Teil gewählt wird. Vorzugsweise weist ein Teil einen sich konisch in Zustellrichtung verjüngenden Abschnitt gefolgt von einem Abschnitt mit konstantem Umfang entlang der Rotationsachse auf. Auf diese Weise kann eine Anlaufschräge an dem Teil ausgebildet werden. Der andere Teil kann in Bezug auf den sich konisch verjüngenden Abschnitt eine Spielpassung und auf den Abschnitt mit konstantem Umfang eine Übermaßpassung aufweisen. Die Eigenschaften der Kompaktzone und der Mischzone, beispielsweise deren Längen, deren Aufbau und dergleichen, können auch über die Längen des konischen Abschnitts, den Winkel des konischen Abschnitts und die Länge des Abschnitts mit konstantem Umfang sowie über das Übermaß der Übermaßpassung kontrolliert werden.

Zur Kontrolle der Entstehung der Kompakt- und der Mischzone können in dem ersten und/oder in dem zweiten Teil außerdem Vertiefungen wie zum Beispiel Nuten angeordnet sein, die die entstehende Schmelze zumindest teilweise aufnehmen und/oder transportieren können. Die Vertiefungen können beispielsweise auch kreisförmig oder rechteckig oder quadratisch sein. Auf dem ersten und/oder auf dem zweiten Teil können außerdem Erhebungen wie beispielsweise Noppen oder längliche Erhebungen angeordnet sein. Kompakt- und Mischzonen beeinflussende Parameter sind beispielsweise die Abmessungen der Vertiefungen oder Erhebungen, die Orientierung in Bezug auf die Rotationsachse, der Verlauf in Bezug auf die Drehrichtung und die Anordnung im Bereich der Rotationsreibschweißnaht. Andere Kontrollmöglichkeiten ergeben sich aus der Relativgeschwindigkeit der Flächen des ersten und zweiten Teils, der Zustellgeschwindigkeit, der Zustellkraft und auch aus dem zeitlichen Verlauf der genannten Größen über den Reibschweißprozess sowie der gesamten Prozesszeit vom Aufschmelzen des Wandmaterials bis zum Erstarren der Schmelze. Bei der Führung des Prozesses wird das Aufschmelzen vorzugsweise nur auf die Wandflächenbereiche der ersten und zweiten Teile beschränkt, um die Stabilität des ersten und zweiten Teils zu erhalten. Dies kann z.B. durch eine relativ kurze Prozesszeit erreicht werden.

Vorteilhafte Ausgestaltungen der Erfindung ergeben sich aus den abhängigen Patentansprüchen und der Beschreibung. Vorteilhafte Weiterbildungen werden durch die Kombination wenigstens eines der unabhängigen Ansprüche mit den Merkmalen eines oder mehrerer Unteransprüche erhalten. Die Zeichnung ergänzt die Beschreibung. Die Figuren zeigen in schematischer Darstellung:
Figur 1 ein erfindungsgemäßes Gehäuse mit einem elektrischen Betriebsmittel,
Figur 2 ein Ausschnitt mit einem Teil des Überlappungsbereichs des Gehäuses aus Figur 1,
Figur 3 eine weitere Ausführungsform eines erfindungsgemäßen Gehäuses,
Figur 4 eine Darstellung des erfindungsgemäßen Verfahrens anhand einer Vorrichtung zur Herstellung.

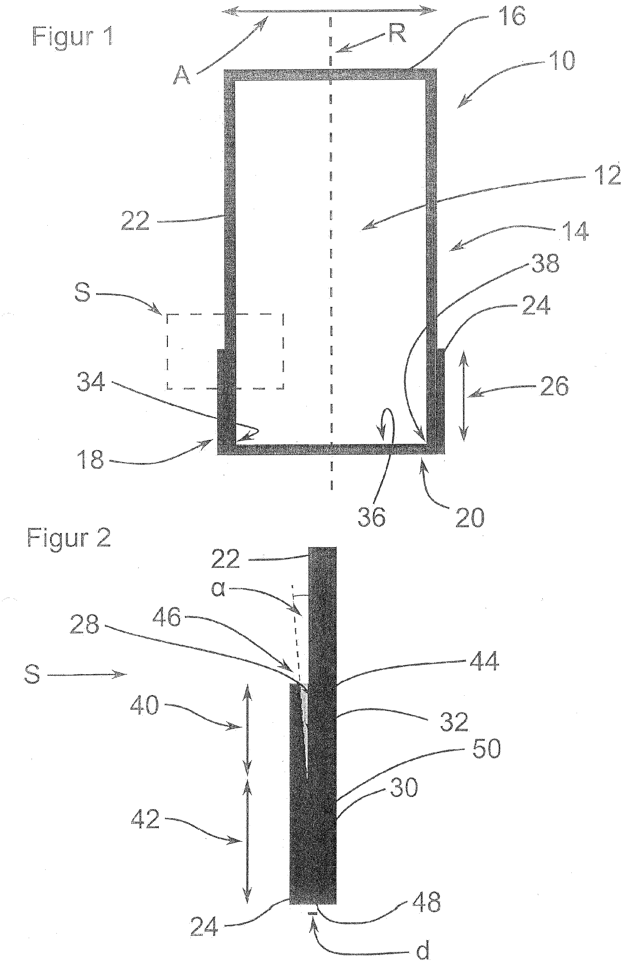

Das in Figur 1 dargestellte erfindungsgemäße Gehäuse 10 beinhaltet eine Lampe 12 und ist explosionsgeschützt nach der Schutzart druckfeste Kapselung Ex-d ausgebildet und zudem wasserdicht. Das Gehäuse 10 legt durch seine zylindrische Form eine Rotationsachse R fest. Das Gehäuse 10 weist ein erstes Teil 14 auf, das rohr- bzw. zylinderförmig ist und einen Boden 16 aufweist. Das erste Teil 14 weist einen Außendurchmesser A von etwa 60 mm auf. Auf das erste Teil 14 ist ein zweites Teil 18 in Form einer Kappe aufgeschweißt. Das erste Teil 14 und das zweite Teil 18 sind jeweils im Spritzgussverfahren hergestellt und bestehen aus amorphem transparentem Polycarbonat. Das erste Teil 14 und das zweite Teil 18 können jedoch auch aus unterschiedlichen Materialien bestehen. Eines der Teile kann beispielsweise aus Glas oder Stahl oder einem anderen Kunststoff als Polycarbonat bestehen.

Die Kappe 18 weist eine Stirnfläche 20 auf, die quer zu der Rotationsachse R orientiert ist. Ein Abschnitt der ersten Wand 22 des ersten Teils 14 überlappt mit einer um das erste Teil 14 umlaufenden zweiten Wand 24 der Kappe 18. Die erste Wand 22 weist eine zylindermantelförmige Außenwandfläche 28 auf. Diese ist mit einer zylindermantelförmigen Innenwandfläche 30 des zweiten Teils 18 über eine Rotationsreibschweißnaht 32 verbunden. Die Außenwandfläche 28 und/oder die Innenwandfläche 30 können auch eine von einer zylindrischen Form abweichende Mantelform aufweisen. Beispielsweise können die Wandflächen konisch zulaufen und/ oder mit Facetten versehen und als Vielkantflächen ausgebildet sein. An dem in dem zweiten Teil 18 angeordneten Ende der ersten Wand 22 des ersten Teils 14 weist das erste Teil 14 eine ringförmige Stirnfläche 34 auf. Zwischen der sich in Umfangsrichtung erstreckenden ringförmigen Stirnfläche 34 und der Stirnfläche 36 der Stirnwand 20 des zweiten Teils 18 befindet sich eine Schweißzone 38 mit erstarrter Schmelze. Die erstarrte Schmelze in der Schweißzone 38 ist durch Reibung der Deckfläche 34 an der Stirnwandfläche 36 entstanden. Die Schmelze kann auch aufgeschmolzenes Material von der Außenwandfläche 28 oder der Innenwandfläche 30 sein, das durch Kapillarwirkung oder durch Materialvortrieb in den Bereich der Schweißzone 38 gelangt ist und dort eine Heißverklebung ausbildet.

In Figur 2 ist ein Ausschnitt S aus dem Gehäuse dargestellt. Die zweite Wand 24 des zweiten Teils 18 weist in einem der Stirnwand 20 fernliegenden ersten Abschnitt 40 eine konisch in Richtung der Stirnwand 20 zulaufende Form auf. In einem entlang der Rotationsachse R näher an der Stirnwand 20 liegenden zweiten Abschnitt 42 weist die Innenwandfläche der zweiten Wand 24 einen konstanten Durchmesser auf. Die Rotationsreibschweißnaht 32 weist in einem Randbereich 46 des Überlappungsbereichs 26 bei dem Übergang des Überlappungsbereiches auf das erste Teil 14 entlang der Rotationsachse R eine Mischzone 44 mit einer inhomogenen Materialverteilung auf. In dem Ausbildungsbeispiel weist die Mischzone 44 insbesondere einen feinporigen Schaum auf. Dieser sorgt in dem Randbereich 46 für eine mechanische Sicherung. Auf diese Weise kann beispielsweise eine Pufferzone geschaffen sein, die insbesondere Kräften nachgibt, die durch eine Explosion im Inneren des Gehäuses 10 hervorgerufen werden können. Solche Kräfte könnten andernfalls zu einem Abscheren des ersten Teils 14 über die Kante des zweiten Teils 18 an dem Randbereich 46 führen.

Die Rotationsreibschweißnaht 32 weist außerdem eine Kompaktzone 48 auf, die in einem entlang der Rotationsachse R näher an der Stirnwand 20 angeordneten Abschnitt der Rotationsreibschweißnaht 32 angeordnet ist. Die Rotationsreibschweißnaht kann auch eine zusätzliche Mischzone aufweisen, die durch die Kompaktzone 48 axial von der Mischzone 44 getrennt ist. Die Kompaktzone 48 weist im Vergleich zur Mischzone 44 eine homogenere Materialverteilung mit einer größeren Dichte auf. Die Rotationsreibschweißnaht 32 weist eine radiale Dicke d auf, die entlang der Rotationsachse R auf Grund des abschnittsweise konischen Verlaufs der ansonsten zylindermantelförmigen Innenwandfläche 30 verschiedene Werte annehmen kann. Das dargestellte Gehäuse 10 weist außerdem Nuten 50 auf, die in der zweiten Wand 24 angeordnet sind und um diese entlang des Umfangs umlaufen. Die Nuten 50 dienen der Aufnahme der Schmelze zur Kontrolle des Schmelzeflusses und als Hinterschneidungen zur mechanischen Sicherung des Gehäuses. Die erste Wand 22 und die zweite Wand 24 sind entlang ihres gesamten Umfangs mit der Rotationsreibschweißnaht verbunden. Die Vertiefungen bzw. Nuten 50 können auch als Taschen ausgebildet sein, die an entlang des Umfangs an einigen Stellen regelmäßig oder unregelmäßig angeordnet sind und beispielsweise der Aufnahme von überschüssiger Schmelze oder der mechanischen Sicherung dienen.

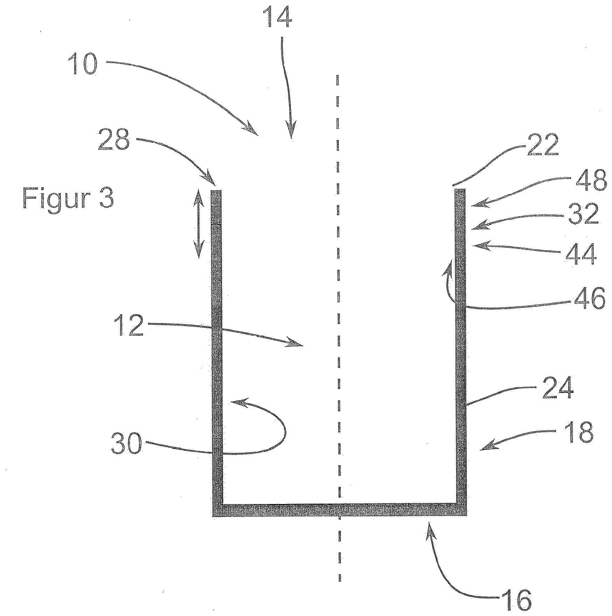

In Figur 3 ist ein weiteres erfindungsgemäßes Gehäuse 10 dargestellt, dass ein elektrisches Betriebsmittel 12 enthält. Das erste Teil 14 ist als massiver Stopfen ausgebildet, der das zweite Teil 18 verschließt. An dem Stopfen ist gleichzeitig das elektrische Betriebsmittel 12 befestigt. Das erste Teil 12 weist eine erste Wand 22 auf, die eine zylindermantelförmige Außenwandfläche 28 aufweist. Das erste Teil 14 und das zweite Teil 18 sind ausschließlich mit einer Rotationsreibschweißnaht 32 zwischen der zylindermantelförmigen Außenfläche 28 und der zylindermantelförmigen Innenwandfläche 30 des zweiten Teils 18 verbunden.

Die Rotationsreibschweißnaht 32 verfügt über eine Mischzone 44, die entlang der Richtung der Rotationsachse an einem Randbereich 46 des Überlappungsbereichs 26 am Übergang von dem ersten Teil 14 auf den Überlappungsbereich 26 angeordnet ist. Der Elastizitätsmodul der Mischzone 44 ist größer als der der Kompaktzone 48, die neben der Mischzone 44, von dem Randbereich 46 entfernt, angeordnet ist. Die Mischzone 44 vermindert an dieser Stelle die Gefahr des Abreißens der zweiten Wand 24 bei einer Explosion im Inneren des Gehäuses 10. Die Kompaktzone 48 der Rotationsreibschweißnaht 32 weist eine homogene Materialverteilung auf und dient zur Dichtung des Gehäuses 10. In dem Überlappungsbereich 26 sind keine Vertiefungen angeordnet, so dass die Rotationsreibschweißnaht hinterschneidungsfrei ausgebildet ist.

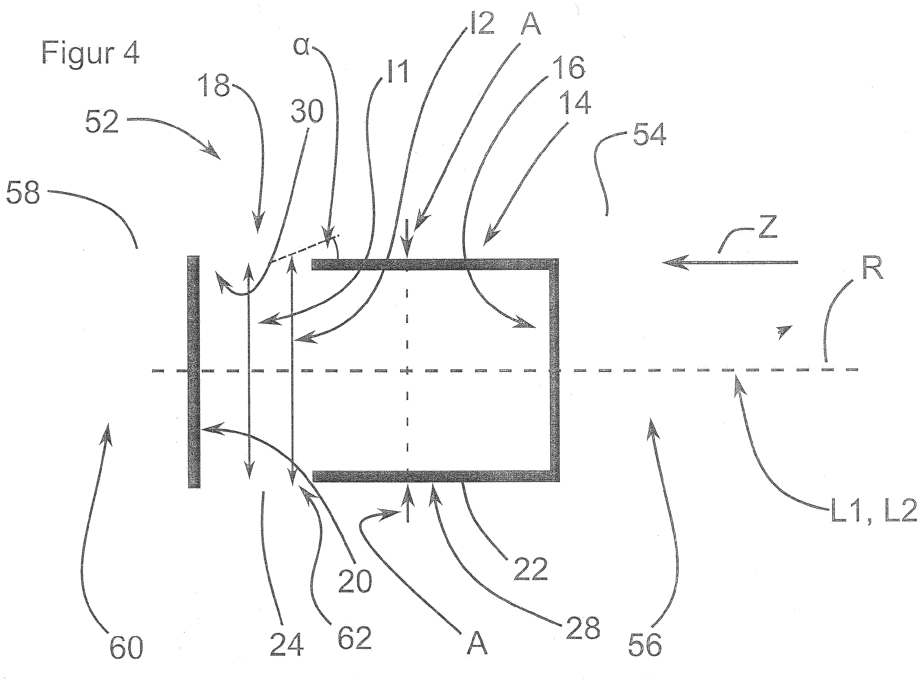

In Figur 4 wird das erfindungsgemäße Verfahren an Hand einer Vorrichtung 52 zur Herstellung eines Gehäuses mit einer Reibschweißnaht dargestellt.

Die Vorrichtung zur Herstellung 52 der Figur 4 weist einen ersten Halter 54 auf, in den ein erstes Teil 14 aus Polycarbonat drehfest gegenüber dem ersten Halter 54 eingespannt ist. An dem ersten Halter 54 ist eine Welle 56 angeordnet, über die der Halter mit einem Rotationsantrieb zu einer Drehung um eine Rotationsachse R angetrieben werden kann. Zudem kann der erste Halter 54 entlang einer Zustellachse Z auf einen zweiten Halter 58 der Vorrichtung 52 zu- oder von diesem translatorisch wegbewegt werden.

Ein zweites Teil 18 aus Polycarbonat in Form einer zylinderförmigen Kappe wird in den zweiten Halter 58 der Vorrichtung 52 eingespannt. Der zweite Halter 58 verfügt über ein Drehlager 60, das gegen Drehung gesperrt werden kann. Das zweite Teil 18 weist eine zweite Wand 24 auf, deren mantelförmige Innenwandfläche 30 zunächst zylindermantelförmig ist und sich zu einem von der Stirnwand 20 fernen Ende 62 der zweiten Wand 24 konisch erweitert. Ansonsten ist die zweite Wand 24 zylindermantelförmig und gerade. Die zweite zylindermantelförmige Innenwandfläche 30 der zweiten Wand 24 weist einen ersten Innendurchmesser I1 in dem zylindermantelförmigen geraden Bereich der zweiten Wand 24 auf. In dem konisch zulaufenden Ende 62 weist die zweite Wand 24 einen zweiten Innendurchmesser I2 auf, wobei der zweite Innendurchmesser I2 auf Grund der konisch schrägen Wandfläche an dem Ende 62 größer ist als der erste Innendurchmesser I1 in dem zylindermantelförmigen geraden Bereich. Durch einen zweiten Innendurchmesser I2, der größer ist als der Außendurchmesser A des ersten Teils und eine konisch zulaufende Form des zweiten Teils kann eine Anlaufschräge mit einem Winkel α geschaffen werden. Der Winkel α beträgt vorzugsweise maximal 3°. In dem zweiten Teil 18 kann beispielsweise eine Lampe angeordnet sein, deren Aufnahme in der Figur 4 angedeutet ist.

Das erste Teil 14 und das zweite Teil 18 sind vorzugsweise konzentrisch zueinander angeordnet. Zwischen den Längsachsen des ersten Teils L1 und des zweiten Teils L2, die in dem Ausführungsbeispiel mit der Rotationsachse R zusammenfallen, kann auch ein paralleler Achsversatz bestehen oder die Längsachsen L1 und L2 können nicht-parallel zueinander verlaufen. Das erste Teil 14 weist eine erste Wand 22 mit einer zylindermantelförmigen Außenwandfläche 28 auf, die einen Außendurchmesser A aufweist. Der Außendurchmesser A ist vorzugsweise größer als der erste Innendurchmesser I1, d.h. das erste Teil weist gegenüber dem zweiten Teil eine Übermaßpassung auf.

Das Verfahren zur Herstellung des Gehäuses 10 kann beispielsweise mit einer Vorrichtung zur Herstellung 52 wie in Figur 4 dargestellt wie folgt ausgeführt werden:
Das Drehlager 60 wird gegen Drehung gesperrt und das erste Teil wird über den ersten Halter 54, über die Welle 56 und den Antriebsmotor in Rotation mit einer bestimmten Rotationsgeschwindigkeit versetzt. Das erste Teil 14 wird entlang einer Zustellachse Z, die in dem Ausführungsbeispiel parallel zur Rotationsachse R verläuft, auf das zweite Teil 18 mit einer bestimmten Zustellgeschwindigkeit zubewegt. Die Zustell- und Rotationsgeschwindigkeit können über den Reibschweißprozess konstant gehalten oder variiert werden. Ab einem bestimmten Abstand des ersten Teils 14 und des zweiten Teils 18 zueinander treten die erste Wand 22 und zweite Wand 24 in Kontakt und Reibungskräfte führen zu einem Aufschmelzen des Materials der Innenwandfläche 30 und der Außenwandfläche 28. Die Zustellbewegung wird so lange ausgeführt, bis der gewünschte Abstand des Bodens 16 von der Stirnwand 20 erreicht ist. Sodann wird die Rotationsbewegung des ersten Halters 54 gebremst, dabei kann die Sperrung des Drehlagers 60 gegen Drehung aufgehoben werden, so dass sich der zweite Halter 58 mit dreht, während die Drehung insgesamt ausläuft.

Es wird ein Gehäuse 10 geschaffen, das ein erstes Teil 14 mit einer ersten Wand 22 und einer Außenwandfläche 28 und ein zweites Teil 18 mit einer zweiten Wand 24 und einer Innenwandfläche 30 aufweist. Die Wandflächen können beispielsweise wenigstens abschnittsweise eine Zylindermantelform aufweisen. Abschnitte der ersten Wand 22 und der zweiten Wand 24 überlappen sich in einem Überlappungsbereich 26. Die erste Wand 22 und die zweite Wand 24 sind mit einer in dem Überlappungsbereich 26 angeordneten Rotationsreibschweißnaht 32 entlang des Umfangs der Wandflächen 28, 30 verbunden. Die Rotationsreibschweißnaht 32 weist eine Kompaktzone 48 mit einem ersten Elastizitätsmodul und eine Mischzone 44 mit einem anderen, zweiten Elastizitätsmodul auf.

### Bezugszeichen:

- 10: Gehäuse
- 12: Elektrisches Betriebsmittel/Lampe
- 14: Erstes Teil
- 16: Boden
- 18: Zweites Teil
- 20: Stirnwand
- 22: Erste Wand
- 24: Zweite Wand
- 26: Überlappungsbereich
- 28: Außenwandfläche
- 30: Innenwandfläche
- 32: Rotationsreibschweißnaht
- 34: Umfängliche Stirnfläche
- 36: Stirnfläche der Stirnwand
- 38: Schweißzone
- 40: Erster Abschnitt
- 42: Zweiter Abschnitt
- 44: Mischzone
- 46: axialer Randbereich
- 48: Kompaktzone
- 50: Vertiefung/ Nut / Tasche
- 52: Vorrichtung zur Herstellung
- 54: Erster Halter
- 56: Welle
- 58: Zweiter Halter
- 60: Drehlager
- 62: Ende
- A: Außendurchmesser
- d: Radiale Dicke
- I1: Erster Innendurchmesser
- I2: Zweiter Innendurchmesser
- L1: Längeachse des ersten Teils
- L2: Längsachse des zweiten Teils
- R: Rotationsachse
- S: Ausschnitt
- Z: Zustellachse
- α: Winkel

## Patentansprüche

1. Gehäuse (10) für elektrische Betriebsmittel (12),
mit einem ersten Teil (14) mit einer ersten Wand (22), die eine Außenwandfläche (28) aufweist, und
mit einem zweiten Teil (18) mit einer zweiten Wand (24), die eine Innenwandfläche (30) aufweist,
wobei die erste Wand (22) und die zweite Wand (24) einen Überlappungsbereich (26) aufweisen und
wobei das erste Teil (14) und das zweite Teil (18) mit einer in dem Überlappungsbereich (26) angeordneten Rotationsreibschweißnaht (32) entlang des Umfangs der Wandflächen (28, 30) verbunden sind, **dadurch gekennzeichnet, dass** die Rotationsreibschweißnaht (32) wenigstens eine Kompaktzone (48) und eine Mischzone (44) aufweist, wobei die Kompaktzone (48) durch vollständig aufgeschmolzenes Material hergestellt ist,
wobei die Mischzone (44) in oder an einem axialen Randbereich (46) des Überlappungsbereichs (26) angeordnet ist, d.h. entlang der Rotationsachse (R) dort, wo sich der Übergang von dem Überlappungsbereich (26) auf das erste Teil (14) oder das zweite Teil (18) befindet, wobei die Mischzone (44) teilweise aufgeschmolzenes Material enthält,
wobei die Mischzone (44) eine höhere Nachgiebigkeit als die Kompaktzone (48) aufweist, und
wobei das Gehäuse explosionsgeschützt nach der Schutzart druckfeste Kapselung (Ex-d) und/oder nach der Schutzart erhöhte Sicherheit (Ex-e) ausgebildet ist.

2. Gehäuse (10) nach einem der vorherigen Ansprüche, **dadurch gekennzeichnet, dass** die Rotationsreibschweißnaht (32) zwei Mischzonen (44) aufweist, die entlang der Rotationsachse (R) durch eine Kompaktzone (48) getrennt sind.

3. Gehäuse (10) nach einem der vorherigen Ansprüche, wobei das erste Teil (14) und/oder das zweite Teil (18) in einer Wandfläche (28, 30) Nuten (50) oder Taschen (50) aufweist.

4. Gehäuse (10) nach Anspruch 3, **dadurch gekennzeichnet, dass** Nuten (50) oder Taschen (50) des ersten Teils (14) und/oder des zweiten Teils (18) entlang des Umfangs der Wandflächen (28, 30) umlaufend in dem Überlappungsbereich (26) angeordnet sind.

5. Gehäuse (10) nach einem der vorherigen Ansprüche, wobei das erste Teil (14) oder das zweite Teil (18) eine Kappe oder ein Stopfen ist.

6. Gehäuse (10) nach einem der vorherigen Ansprüche, wobei die ersten Wand (22) und/oder die zweite Wand (24) aus amorphem Kunststoff besteht.

7. Gehäuse (10) nach einem der vorherigen Ansprüche, **dadurch gekennzeichnet, dass** die erste Wand (22) und die zweite Wand (24) aus unterschiedlichen Materialien bestehen.

8. Gehäuse (10) nach einem der vorherigen Ansprüche, **dadurch gekennzeichnet, dass** die erste Wand (22) und/oder die zweite Wand (24) aus Polycarbonat besteht.

9. Gehäuse (10) nach einem der vorherigen Ansprüche, wobei eine Wandfläche (28, 30) der ersten Wand (22) und/oder der zweiten Wand (24) wenigstens innerhalb des Überlappungsbereiches (26) zumindest abschnittsweise eine konische Form aufweist.

10. Gehäuse (10) nach Anspruch 9, **dadurch gekennzeichnet, dass** die konische Form durch einen Winkel (α) charakterisiert ist, der kleiner als 3° ist.

11. Gehäuse (10) nach einem der vorherigen Ansprüche, wobei das erste Teil (14) und das zweite Teil (18) auch an einer Stirnfläche (34, 36) des ersten Teils und einer Stirnfläche (34, 36) des zweiten Teils miteinander verschweißt sind.

12. Gehäuse (10) nach einem der Ansprüche 1 - 10, wobei das erste Teil (14) und das zweite Teil (18) ausschließlich durch eine Rotationsreibschweißnaht (32) auf den mantelförmigen Wandflächen (28, 30) entlang ihres Umfangs verbunden sind.

13. Verfahren zur Herstellung eines explosionsgeschützt nach der Schutzart druckfeste Kapselung (Ex-d) und/oder nach der Schutzart erhöhte Sicherheit (Ex-e) ausgebildeten Gehäuses (10), insbesondere für elektrische Betriebsmittel (12), wobei das Gehäuse (10) eine Rotationsachse (R) festlegt, ein erstes Teil (14) mit einer ersten Wand (22) aufweist, die eine Außenwandfläche (28) aufweist und
ein zweites Teil (18) mit einer zweiten Wand (24) aufweist, die eine Innenwandfläche (30) aufweist,
und wobei die ersten Wand (22) und die zweite Wand (24) auf den Wandflächen (28, 30) entlang ihres Umfangs durch Rotationsreibschweißen verbunden werden, wobei eine Rotationsreibschweißnaht (32) mit einer Kompaktzone (48) und einer Mischzone (44) ausgebildet wird, wobei die Mischzone (44) eine höhere Nachgiebigkeit als die Kompaktzone (48) aufweist, wobei die Kompaktzone (48) durch vollständig aufgeschmolzenes Material hergestellt ist, wobei die Mischzone (44) in oder an einem axialen Randbereich (46) des Überlappungsbereichs (26) angeordnet ist, d.h. entlang der Rotationsachse (R) dort, wo sich der Übergang von dem Überlappungsbereich (26) auf das erste Teil (14) oder das zweite Teil (18) befindet, wobei die Mischzone (44) teilweise aufgeschmolzenes Material enthält.

## Claims

1. Housing (10) for electrical equipment (12),
with a first part (14) with a first wall (22) having an outer wall surface (28), and with a second part (18) with a second wall (24) having an inner wall surface (30),
wherein the first wall (22) and the second wall (24) have an overlap region (26), and
wherein the first part (14) and the second part (18) are connected along the periphery of the wall surfaces (28, 30) by means of a rotational friction weld seam (32) arranged in the overlap region (26),
**characterised in that** the rotational friction weld seam (32) has at least one compact zone (48) and a mixed zone (44),
wherein the compact zone (48) is produced by fully melted material,
wherein the mixed zone (44) is arranged in or on an axial edge region (46) of the overlap region (26), i.e. along the rotation axis (R) at the location of the transition from the overlap region (26) to the first part (14) or to the second part (18), wherein the mixed zone contains partially melted material,
wherein the mixed zone (44) has a higher resilience than the compact zone (48), and
wherein the housing is formed explosion-protected with the protection type of pressure-resistant encapsulation (Ex-d) and/or the protection type of increased safety (Ex-e).

2. Housing (10) according to one of the preceding claims, **characterised in that** the rotational friction weld seam (32) has two mixed zones (44) which are separated along the rotation axis (R) by a compact zone (48).

3. Housing (10) according to any of the preceding claims, wherein the first part (14) and/or the second part (18) comprises grooves (50) or pockets (50) in a wall surface (28, 30).

4. Housing (10) according to claim 3, **characterised in that** grooves (50) or pockets (50) of the first part (14) and/or of the second part (18) are arranged running around the periphery of the wall surfaces (28, 30) in the overlap region (26).

5. Housing (10) according to any of the preceding claims, wherein the first part (14) or the second part (18) is a cap or a plug.

6. Housing (10) according to any of the preceding claims, wherein the first wall (22) and/or the second wall (24) consists of an amorphous plastic.

7. Housing (10) according to any of the preceding claims, **characterised in that** the first wall (22) and the second wall (24) consist of different materials.

8. Housing (10) according to any of the preceding claims, **characterised in that** the first wall (22) and/or the second wall (24) consist of polycarbonate.

9. Housing (10) according to any of the preceding claims, wherein a wall surface (28, 30) of the first wall (22) and/or of the second wall (24) has a conical form at least in portions, at least inside the overlap region (26).

10. Housing (10) according to claim 9, **characterised in that** the conical form is distinguished by an angle (α) which is less than 3°.

11. Housing (10) according to any of the preceding claims, wherein the first part (14) and the second part (18) are welded together also at an end face (34, 36) of the first part and an end face (34, 36) of the second part.

12. Housing (10) according to any of claims 1 - 10, wherein the first part (14) and the second part (18) are connected along their periphery exclusively by a rotational friction weld seam (32) on the casing-like wall surfaces (28, 30).

13. Method for production of a housing (10), which is formed explosion-protected with the protection type of pressure-resistant encapsulation (Ex-d) and/or the protection type of increased safety (Ex-e), in particular for electrical equipment (12), wherein the housing (10) establishes a rotation axis (R), has a first part (14) with a first wall (22) having an outer wall surface (28), and has a second part (18) with a second wall (24) having an inner wall surface (30),
and wherein the first wall (22) and the second wall (24) are connected along their periphery at the wall surfaces (28, 30) by means of rotational friction welding, wherein a rotational friction weld seam (32) is formed with a compact zone (48) and a mixed zone (44), wherein the mixed zone (44) has a higher resilience than the compact zone (48), wherein the compact zone (48) is produced by fully melted material, wherein the mixed zone (44) is arranged in or on an axial edge region (46) of the overlap region (26), i.e. along the rotation axis (R) at the location of the transition from the overlap region (26) to the first part (14) or to the second part (18), wherein the mixed zone (44) contains partially melted material.

## Revendications

1. Boîtier (10) destiné à des matériels électriques (12), comportant une première partie (14) dotée d'une première paroi (22) qui présente une surface de paroi extérieure (28), et une deuxième partie (18) dotée d'une deuxième paroi (24) qui présente une surface de paroi intérieure (30), la première paroi (22) et la deuxième paroi (24) présentant un domaine de chevauchement (26) et la première partie (14) et la deuxième partie (18) étant reliées par un joint de soudage par frottement rotatif disposé dans le domaine de chevauchement (26) sur la périphérie des surfaces de paroi (28, 30),
**caractérisé en ce que** le joint de soudage par frottement rotatif (32) présente au moins une zone compacte (48) et une zone mixte (44), la zone compacte (48) étant obtenue au moyen de matériau complètement fondu,
la zone mixte (44) étant disposée dans ou sur un domaine de bord axial (46) du domaine de chevauchement (26), c'est-à-dire le long de l'axe de rotation (R) là où se trouve la transition depuis le domaine de chevauchement (26) jusqu'à la première partie (14) ou jusqu'à la deuxième partie (18), la zone mixte (44) contenant du matériau partiellement fondu,
la zone mixte (44) présentant une souplesse supérieure à celle de la zone compacte (48), et
le boîtier étant protégé contre l'explosion selon un mode de protection encapsulage résistant à la pression (Ex-d) et/ou selon le mode protection sécurité renforcée (Ex-e).

2. Boîtier (10) selon l'une des revendications qui précèdent, **caractérisé en ce que** le joint de soudage par frottement rotatif (32) présente deux zones mixtes (44) qui sont séparées le long de l'axe de rotation (R) par une zone compacte (48).

3. Boîtier (10) selon l'une des revendications qui précèdent, dans lequel la première pièce (14) et/ou la deuxième pièce (18) présente/présentent des rainures (50) ou des poches (50) dans une surface de paroi (28, 30).

4. Boîtier (10) selon la revendication 3 **caractérisé en ce que** des rainures (50), ou des poches (50) de la première pièce (14) et/ou de la deuxième pièce (18) sont disposées sur la périphérie des surfaces de paroi (28, 30) de façon circulaire dans le domaine de chevauchement (26).

5. Boîtier (10) selon l'une des revendications qui précèdent, la première pièce (14) ou la deuxième pièce (18) étant un couvercle ou un bouchon.

6. Boîtier (10) selon l'une des revendications qui précèdent dans lequel la première paroi (22) et/ou la deuxième paroi (24) est/sont constituée(s) d'une matière de synthèse amorphe.

7. Boîtier (10) selon l'une des revendications qui précèdent **caractérisé en ce que** la première paroi (22) et la deuxième paroi (24) sont constituées de matériaux différents.

8. Boîtier (10) selon l'une des revendications qui précèdent **caractérisé en ce que** la première paroi (22) et/ou la deuxième paroi (24) est/sont constituée(s) de polycarbonate.

9. Boîtier (10) selon l'une des revendications qui précèdent, une surface de paroi (28, 30) de la première paroi (22) et/ou de la deuxième paroi (24) présentant, au minimum partiellement, une forme conique au moins dans le domaine de chevauchement (26).

10. Boîtier (10) selon la revendication 9 **caractérisé en ce que** la forme conique est **caractérisée par** un angle (oc) qui est inférieur à 3°.

11. Boîtier (10) selon l'une des revendications qui précèdent, la première partie (14) et la deuxième partie (18) étant également soudées ensemble sur une surface frontale (34, 36) de la première partie et sur une surface frontale (34, 36) de la deuxième partie.

12. Boîtier (10) selon l'une des revendications 1 à 10, la première partie (14) et la deuxième partie (18) étant reliées exclusivement au moyen d'un joint de soudage par frottement rotatif (32) réalisé sur les surfaces de paroi enveloppantes (28, 30) sur leur périphérie.

13. Procédé de fabrication d'un boîtier (10) protégé de l'explosion selon le mode de protection par emboîtage résistant à la pression (Ex-d) et/ou selon le mode protection haute sécurité (Ex-e) destiné en particulier à des matériels électriques (12), le boîtier (10) déterminant un axe de rotation (R), une première partie (14) présentant une première paroi (22) qui est dotée d'une surface de paroi extérieure (28), et une deuxième partie (18) comportant une deuxième paroi (24) qui présente une surface de paroi intérieure (30), et la première paroi (22) et la deuxième paroi (24) étant reliées au niveau des surfaces de paroi (28, 30) sur leur périphérie par soudage par frottement rotatif, un joint de soudage par frottement rotatif comportant une zone compacte (48) et une zone mixte (44), la zone mixte (44) présentant une plus grande souplesse que la zone compacte (48), la zone compacte (48) étant obtenue avec un matériau complètement fondu, la zone mixte (44) étant disposée dans ou sur une zone de bord axiale (46) du domaine de chevauchement (26), c'est-à-dire le long de l'axe de rotation (R) là où se trouve la transition depuis le domaine de chevauchement (26) jusqu'à la première partie (14) ou jusqu'à la deuxième partie (18), la zone mixte (44) contenant du matériau partiellement fondu.
